# EUROPEAN PATENT APPLICATION

(11) **EP 2 704 545 A2**
(43) Date of publication of application: **05.03.2014**
(21) Application number: 13171425.5
(22) Date of filing: 11.06.2013
(51) Int. Cl.: H05K 7/14

(54) **Electronic device, manufacturing method and connection method**

(30) Priority: 29.08.2012 JP 2012189002
(71) Applicant: FUJITSU LIMITED, Kawasaki-shi, Kanagawa 211-8588 (JP)
(72) Inventor: Hashimoto, Shohei, Kanagawa, 211-8588 (JP)
(74) Representative: HOFFMANN EITLE

(57) **Abstract**

An electronic device includes: a case; a first board that includes a first connector; a positioning section that positions the first board with respect to the case; a second board that includes a second connector; a guide rail that has an end portion on the first board side formed with a fitting port into which the first connector fits, and that guides the second connector towards the first connector that is fitted into the fitting port; a pair of sloping portions formed to edge portions on both guide rail pivot direction sides of the fitting port; and a pair of stoppers respectively disposed at each of the guide rail pivot direction sides so as to restrict the pivot range of the guide rail such that the first connector is insertable between the pair of sloping portions.

## Description

### FIELD

The embodiments discussed herein are related to an electronic device, an electronic device manufacturing method, and a connection method of a board contained in an electronic device.

### BACKGROUND

A guide structure is known that includes: a main board including an end portion of a connector; a pair of guide rails that are attached to an end portion of the main board; and a sub board that includes an end portion of a connector that is connected to the connector of the main board and that is mounted to the main board along the pair of guide rails.

In this type of guide structure, the precision of positioning of the sub board connector with respect to the main board connector is enhanced due to the pair of guide rails being attached to the end portion of the main board and directly positioned to the main board.

### [Related Patent Documents]

### Japanese Laid-Open Patent Publication No. 5-090727

However, in the guide structure described above there is the possibility that the mounting space for electronic components on the main board is made narrower by the amount of attachment of the end portions of the pair of guide rails to the main board.

### SUMMARY

An object of one aspect of technology disclosed herein is to lessen the reduction in mounting space for electronic components on a first board.

According to an aspect of the embodiments, an electronic device includes: a case; a first board that includes a first connector and that is inserted into one side of the case; a positioning section that is provided to the case and that positions the first board with respect to the case; a second board that includes a second connector that connects to the first connector, and that is inserted into another side of the case from the opposite side to the first board; a guide rail that is disposed along the second board insertion direction at the other side of the case, that is pivotally supported by the case, that has an end portion on the first board side formed with a fitting port into which the first connector fits, that slidably supports the second board, and that guides the second connector towards the first connector that is fitted into the fitting port; a pair of sloping portions formed to edge portions on both guide rail pivot direction sides of the fitting port so as to slope in the direction separating from each other on progression towards the open side; and a pair of stoppers respectively disposed at each of the guide rail pivot direction sides so as to restrict the pivot range of the guide rail such that the first connector is insertable between the pair of sloping portions.

### BRIEF DESCRIPTION OF DRAWINGS

Fig. 1 is a perspective view illustrating a rack that houses rack mounted devices that are an exemplary embodiment of electronic devices;
Fig. 2 is a plan view illustrating a main unit in a state prior to housing in a mounting case configuring one of the rack mounted devices illustrated in Fig 1;
Fig. 3 is a plan view illustrating the main unit in a state housed in the mounting case illustrated in Fig. 2;
Fig. 4 is a plan view illustrating a sub unit in a state prior to housing in the mounting case configuring one of the rack mounted devices illustrated in Fig. 1;
Fig. 5 is a perspective view illustrating a positioning section of the mounting case and the main unit case illustrated in Fig. 3;
Fig. 6 is a perspective view illustrating the sub unit illustrated in Fig 4;
Fig. 7A is a perspective view illustrating a state prior to connecting a main-side connector and a sub-side connector together;
Fig. 7B is a perspective view illustrating from another direction a state prior to connecting the main-side connector and the sub-side connector illustrated in Fig. 7A together;
Fig. 8 is a cross-section taken on line F8-F8 of Fig. 6;
Fig. 9 is a plan view illustrating a state prior to fitting a main-side connector into a fitting port of a guide rail;
Fig. 10 is a cross-section taken on line F10- F10 of Fig. 9;
Fig. 11 is a plan view illustrating a fitting port of a guide rail;
Fig. 12 is a plan view illustrating a pivot range of a guide rail;
Fig. 13 is a plan view illustrating a contact state of an outer peripheral edge portion of a main-side connector with a sloping portion of a guide rail; and
Fig. 14 is a plan view illustrating a state in which a main-side connector is fitted into a fitting port of a guide rail.

### DESCRIPTION OF EMBODIMENTS

Explanation follows regarding an exemplary embodiment of an electronic device disclosed herein, with reference to the drawings. Note that in each of the drawings the arrow X indicates the front side in the front-rear direction of the electronic device (device front-rear direction), as appropriate. The arrow Z indicates the top side in the top-bottom direction of the electronic device (device top-bottom direction). The arrow Y indicates the width direction of the electronic device (device width direction).

### Rack Configuration

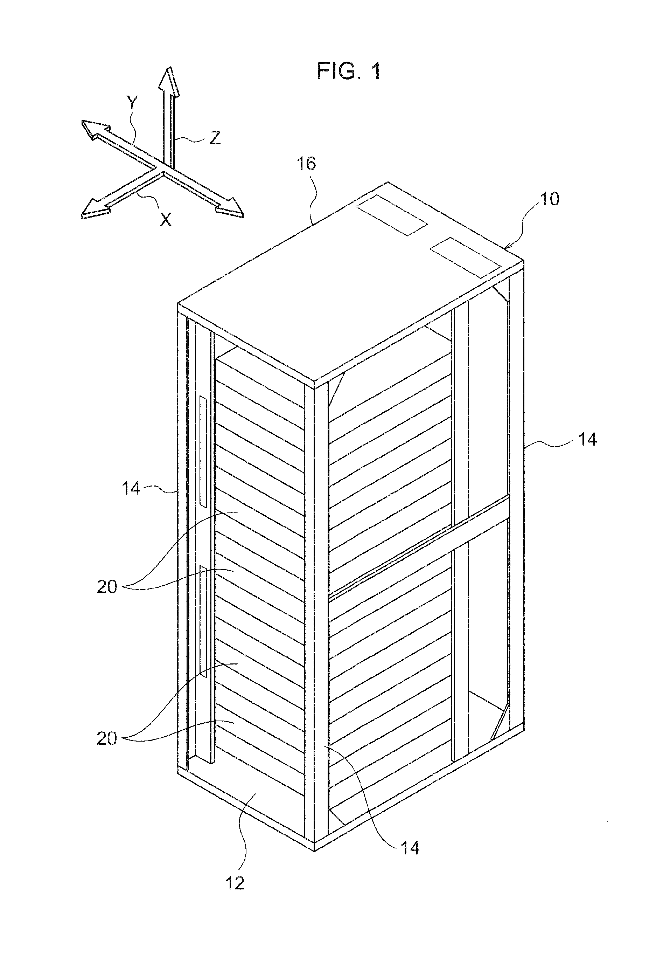

As illustrated in Fig. 1, rack mounted devices 20 serving as examples of electronic devices are housed in a rack 10. The rack 10 is formed in a box shape, and includes a base 12, plural external peripheral pillars 14 that extend upright from external peripheral portions of the base 12, and a top wall 16 that is supported by the external peripheral pillars 14. There are, along the device up-down direction, plural of the rack mounted devices 20 detachably mounted inside the rack 10.

### Overall Configuration of Rack Mounted Device

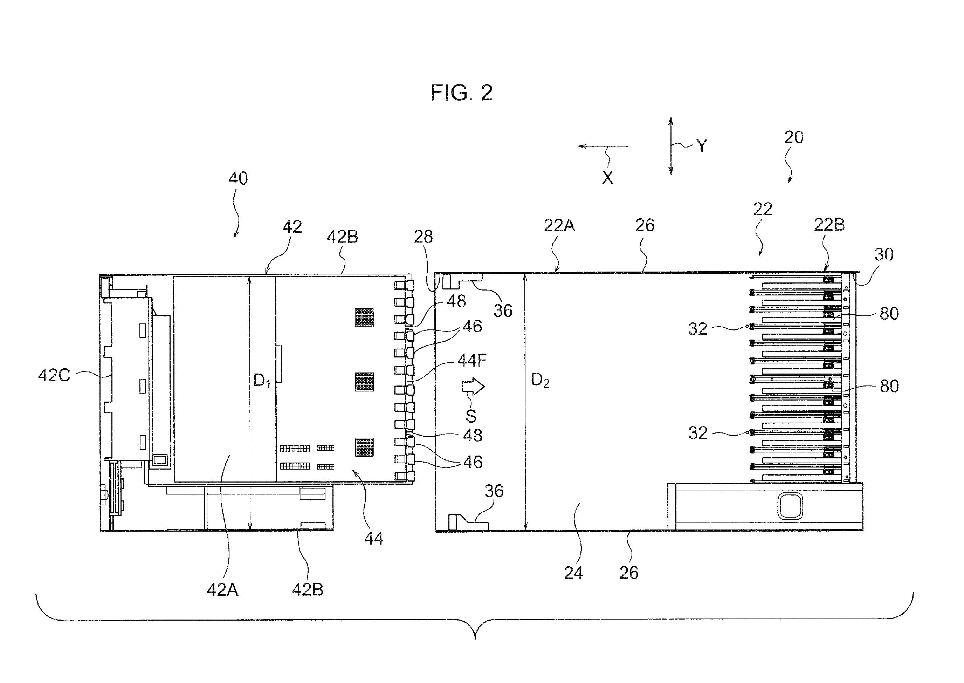

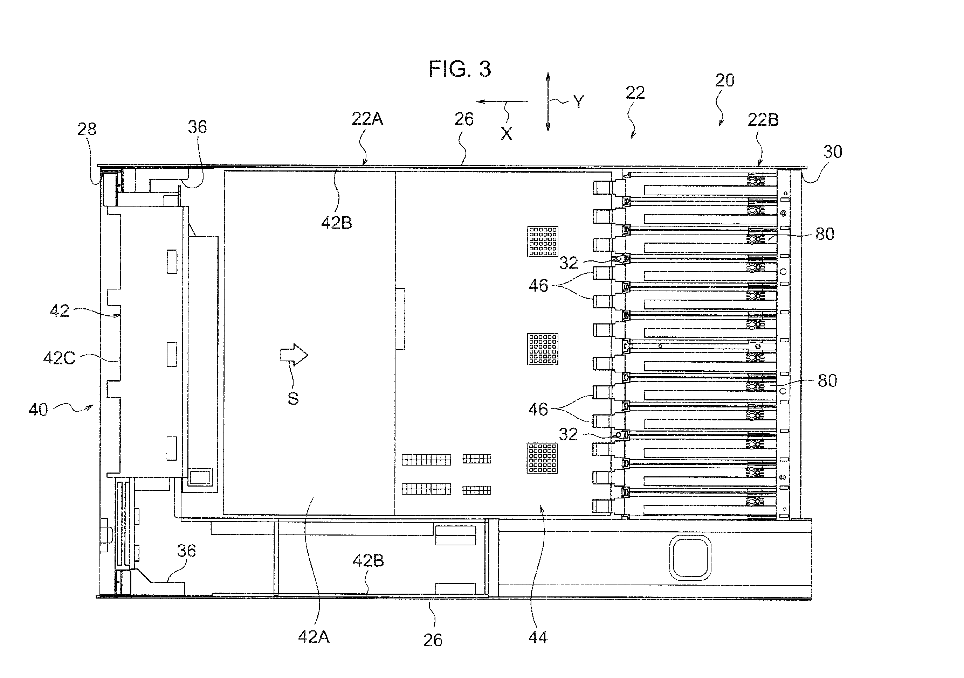

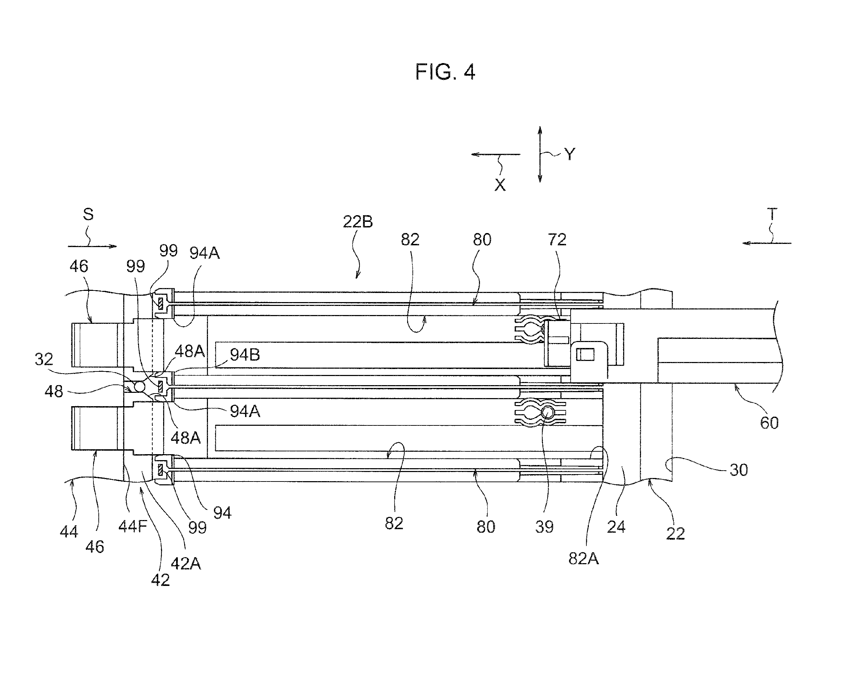

As illustrated in Fig. 2 and Fig. 3, the rack mounted devices 20 each include a mounting case 22 serving as an example of a case, a main unit 40, and a sub unit 60, described later (see Fig. 4). The mounting case 22 is formed in a rectangular shape with its long sides oriented along the device front-rear direction in plan view. The mounting case 22 is formed from sheet metal and has a bottom wall section 24 and a pair of guide wall sections 26 that extend up from the two device width direction (arrow Y direction) edge portions of the bottom wall section 24.

The mounting case 22 has openings at both device front-rear direction sides, with an insertion opening 28 formed at one end side (the front end side) for inserting the main unit 40 into, and an insertion opening 30 formed in the other end side (the rear end side) for inserting the sub unit 60 into. Namely, the sub unit 60 is inserted into the mounting case 22 from the opposite side to that of the main unit 40. Inside the mounting case 22 at one side (the front side) there is a main unit housing section 22A that houses the main unit 40 that has been inserted in through the insertion opening 28. Moreover, at the other end side (the rear end side) inside the mounting case 22 there is a sub unit housing section 22B that houses the sub unit 60 that has been inserted in through the insertion opening 30.

### Main Unit Configuration

The main unit 40 is formed in a rectangular shape with its long sides oriented in the device front-rear direction in plan view, and includes a main unit case 42, and a main board 44 that is housed in the main unit case 42.

The main unit case 42 is formed from sheet metal, and has a bottom wall section 42A, a pair of side wall sections 42B that extend up from the two device width direction edge portions of the bottom wall section 42A, and a rear wall section 42C that extends up from a rear edge portion of the bottom wall section 42A.

A separation D₁ of the pair of side wall sections 42B of the main unit case 42 is slightly narrower than a separation D₂ of the pair of guide wall sections 26 of the mounting case 22. Thus, when the main unit 40 is being inserted into the mounting case 22 through the insertion opening 28, the pair of side wall sections 42B are guided by the pair of guide wall sections 26 that extend along the main unit 40 insertion direction (arrow S direction). Namely, the pair of guide wall sections 26 function as guide sections (guide rails) to guide the main unit 40 towards the inside of the mounting case 22.

The main board 44 serving as an example of a first board is housed at the insertion direction front side of the main unit 40. The main board 44 is disposed with the board thickness direction oriented in the device up-down direction (the arrow Z direction in Fig. 1), and with its width direction oriented in the device width direction (the arrow Y direction). The main board 44 is fixed to the bottom wall section 42A in an overlapping state with the bottom wall section 42A of the main unit case 42.

The main board 44 configures, for example, a mother board (main board) mounted with plural electronic components such as a Central Processing Unit (CPU) and a memory. Plural main-side connectors 46 serving as examples of plural first connectors are provided at an insertion direction front end portion 44F of the main board 44. The main-side connectors 46 are electrically connected to plural electronic components mounted to the main board 44 by an electrical circuit formed on the main board 44.

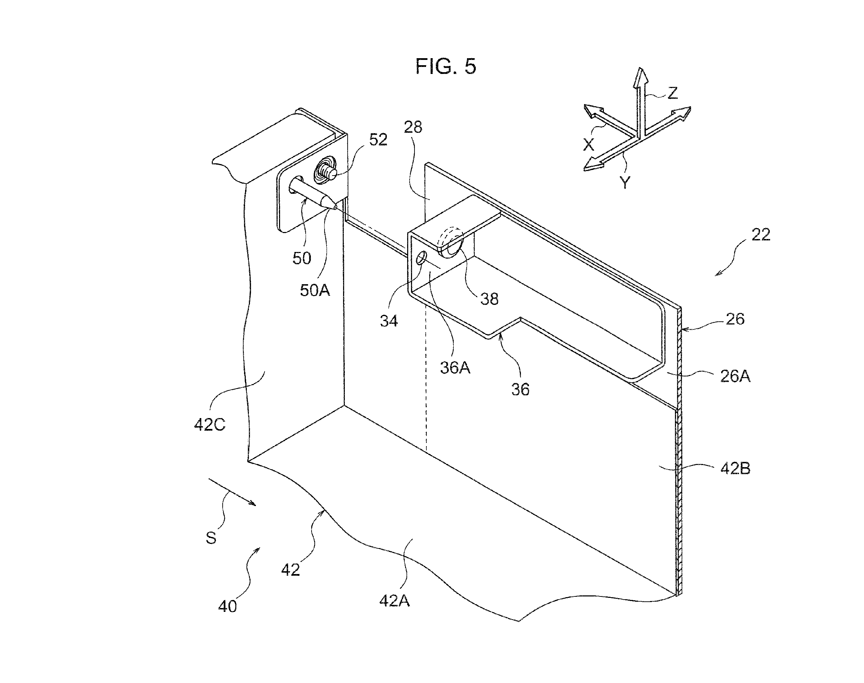

Explanation follows regarding a positioning structure of the main unit 40 with respect to the mounting case 22. The mounting case 22 is provided with a pair of engaging pins 32 for positioning the insertion direction front side of the main unit 40, and a pair of engaged holes 34 (see Fig. 5) for positioning the insertion direction rear side of the main unit 40.

The pair of engaging pins 32, serving as an example of a pair of front side positioning sections, are provided on the far side of the main unit housing section 22A, and separated from each other in the device width direction. Each of the engaging pins 32 projects out from the bottom wall section 24 of the mounting case 22, as illustrated in Fig. 4.

Moreover, engagement grooves 48 into which the engaging pins 32 are inserted are formed to the insertion direction front end portion of the bottom wall section 42A of the main unit case 42. The groove width of the engagement grooves 48 is slightly larger than the diameter of the engaging pins 32. The engaging pins 32 are accordingly engaged in the main board 44 width direction with the engagement grooves 48 by inserting the engaging pins 32 into the engagement groove 48. The front end of the main unit 40 is thereby positioned in the main board 44 width direction with respect to the mounting case 22. Note that a pair of sloping guide walls 48A is formed to each of the engagement grooves 48 to guide insertion of the engaging pins 32 with respect to the engagement grooves 48.

As illustrated in Fig. 5, brackets 36 provided to an inner wall face 26A of the guide wall sections 26 of the mounting case 22 are formed with the engaged holes 34 that serve as rear side positioning sections. The brackets 36 are provided running along an upper edge portion of the guide wall sections 26, and are disposed above the side wall sections 42B of the main unit case 42. Facing wall portions 36A are provided to the brackets 36 so as to face the rear wall section 42C of the main unit case 42. The engaged holes 34 are formed in the facing wall portions 36A in circular shapes.

Moreover, circular rod shaped engaging pins 50 are provided to the rear wall section 42C of the main unit case 42 so as to project out towards the main unit 40 insertion direction (arrow S direction) front side. The diameter of the engaging pins 50 is slightly smaller than the diameter of the engaged holes 34. The rear side of the main unit 40 is accordingly positioned in both the main board 44 (see Fig. 2) width direction and board thickness direction with respect to the mounting case 22 by insertion of the engaging pins 50 into the engaged holes 34. Note that the leading end portions of the engaging pins 50 are provided with tapers 50A to guide insertion of the engaging pins 50 with respect to the engaged holes 34.

Attachment holes, not illustrated in the drawings, are also formed in the facing wall portions 36A. Nuts 38 are joined to the peripheral edge portions of the attachment holes. The rear wall section 42C of the main unit case 42 is fixed to the facing wall portions 36A of the brackets 36 by passing bolts 52 through the attachment holes and the rear wall section 42C of the main unit case 42 and fastening into the nuts 38.

### Sub Unit Configuration

As illustrated in Fig. 4, plural guide rails 80 are provided to the sub unit housing section 22B formed on the other side (the front side) of the mounting case 22. The guide rails 80 are arrayed at intervals along the device width direction so as to correspond to the positions of the main-side connectors 46. The sub unit 60 that has been inserted along the guide rails 80 into the mounting case 22 through the insertion opening 30 is housed in the sub unit housing section 22B.

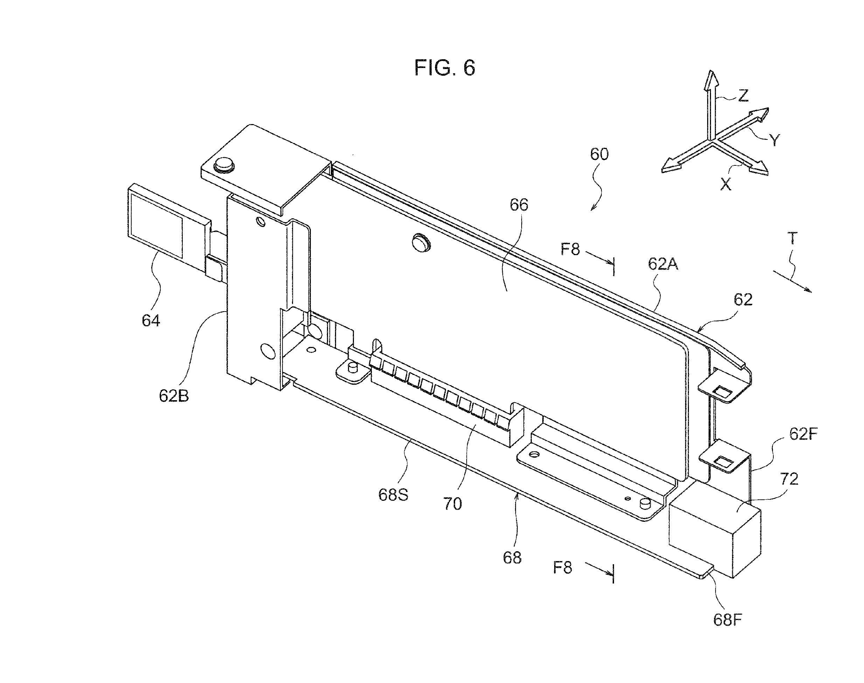

As illustrated in Fig. 6, the sub unit 60 configures a plug-in expansion unit and is formed overall in a rectangular box shape having long sides oriented along the device front-rear direction. The sub unit 60 includes a metal sub unit case 62, a sub board 66 serving as an example of a second board, a connection board 68 and a sub-side connector 72.

The sub unit case 62 houses the sub board 66 in an upright orientation, and includes a side cover section 62A that covers the sub board 66 from one board thickness direction side, and a back cover 62B that covers the sub board 66 from the insertion direction (arrow T direction) rear side. A lever 64 that is provided to the back cover 62B is gripped by a user when the sub unit 60 is being inserted into the mounting case 22.

The sub board 66 configures, for example, an expansion board (expansion card) such as an interface board mounted with plural electronic components, and is disposed with the board thickness direction along the width direction of the main board 44, so as to be orthogonal to the main board 44 (see Fig. 2). An electrical circuit is formed to the sub board 66 for electrically connecting plural electronic components. A connector (not illustrated in the drawings) is provided at an insertion direction rear end portion of the sub board 66 for cable connection etc., not illustrated in the drawings. The connector is electrically connected to the electrical circuit formed on the sub board 66.

The connection board 68 is disposed below the sub board 66. The connection board 68 is disposed orthogonally to the sub board 66. The connection board 68 is, similarly to the sub board 66, mounted with plural electronic components and is electrically connected to the sub board 66 through a connector 70 provided on the top face of the connection board 68.

The sub-side connector 72 serving as an example of a second connector is provided at an insertion direction front end portion 68F of the connection board 68. The sub-side connector 72 is formed in a box shape and is electrically connected to the electrical circuit formed on the connection board 68. The sub-side connector 72 projects out from a front end portion 62F of the sub unit case 62. The electrical circuit on the sub board 66 and the electrical circuit on the main board 44 are electrically connected together by connecting the sub-side connector 72 to the respective main-side connector 46 provided to the main board 44.

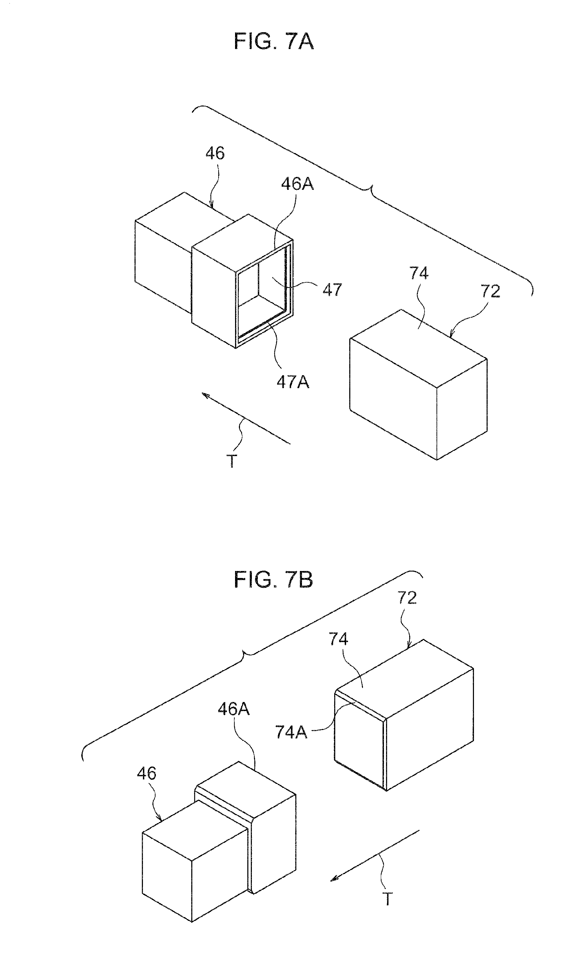

More specifically, as illustrated in Fig. 7A and Fig. 7B, the sub-side connector 72 includes an insertion portion 74 that is inserted into a connection port 47 formed to the respective main-side connector 46. The outer peripheral edge portions of the insertion portion 74 are formed by beveling with beveled portions 74A around the entire periphery. Moreover, the inner peripheral edge portions of the connection port 47 of the main-side connector 46 are also formed by beveling with beveled portions 47A. Insertion of the insertion portion 74 into the connection port 47 is accordingly guided by the beveled portions 47A, 74A. Note that beveled portions may be provided to the outer peripheral edge portions of the insertion portion 74, to the inner peripheral edge portions of the connection port 47, or to the outer peripheral edge portions of the insertion portion 74 and the inner peripheral edge portions of the connection port 47.

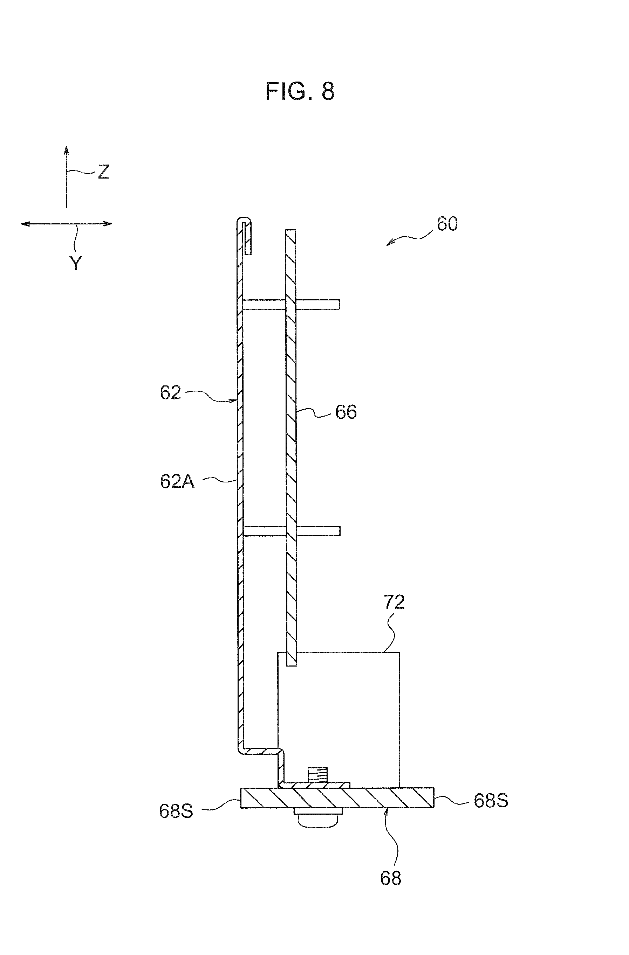

As illustrated in Fig. 8, slide sections 68S are provided at both width direction end portions of the connection board 68, and are slidably supported by the guide rails 80, as described later. The slide sections 68S jut out further on both sub board 66 board thickness direction sides than the sub board 66 and the sub-side connector 72.

### Guide Rail Configuration

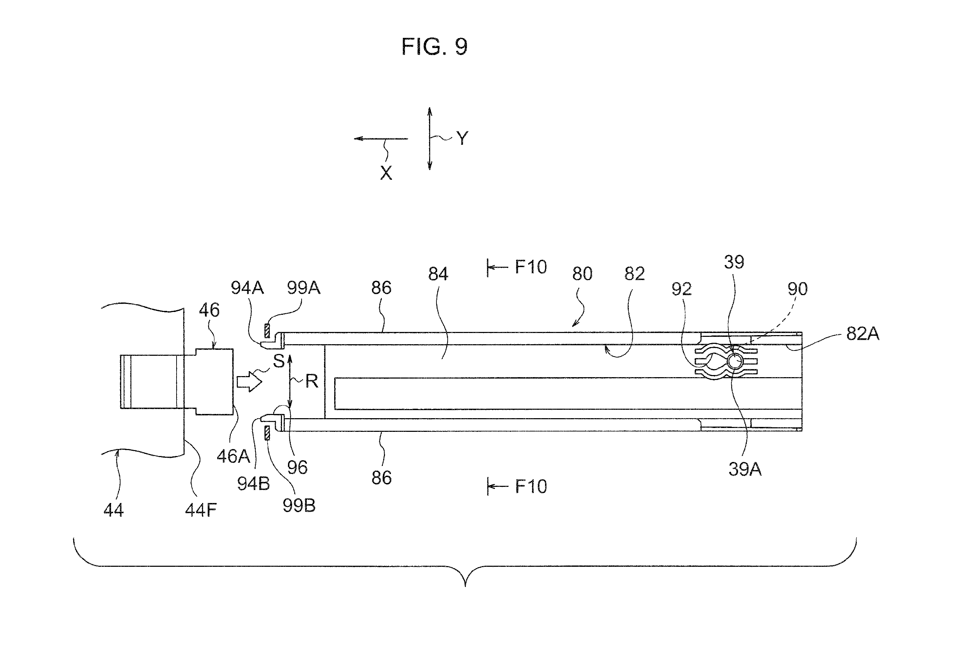

As illustrated in Fig. 4, the guide rails 80 are disposed along the sub unit 60 insertion direction (the arrow T direction) on the other side of the mounting case 22. Guide indentations 82 are formed to the guide rails 80 so as to extend along the guide rail 80 length direction, as illustrated in Fig. 9. Indentation openings 82A are formed to the guide indentations 82 at the opposite side to that of the main board 44, and a lower portion of the sub unit 60 is inserted into the indentation openings 82A. The sub unit 60 is guided along the guide rails 80 towards the inside of the mounting case 22 by the lower portion of the sub unit 60 being inserted through the indentation openings 82A and into the guide indentations 82.

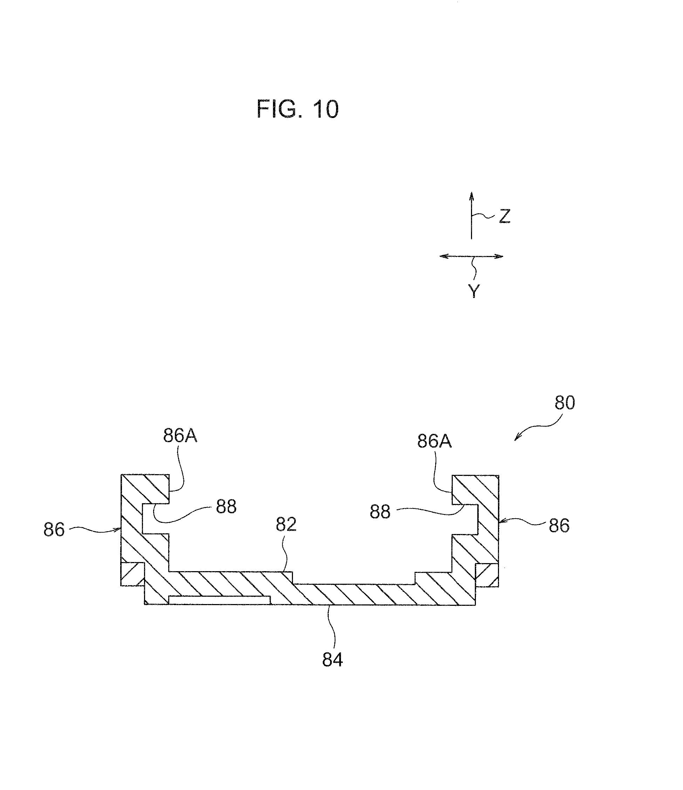

Specifically, as illustrated in Fig. 10, the guide rails 80 include bottom wall portions 84 formed overall with U-shaped cross-section profiles opening upwards, and with a pair of side wall portions 86 that face each other along the device width direction. The guide indentations 82 for insertion of the main-side connectors 46 are formed between the pair of side wall portions 86. A pair of groove portions 88 are formed to inside faces 86A of the pair of side wall portions 86 so as to extend along the guide indentations 82 and to slidably support the slide sections 68S (see Fig. 8) at both sides of the connection board 68. The sub-side connector 72 is accordingly positioned in both the main board 44 board thickness direction and width direction with respect to the respective main-side connector 46 that has been fitted into fitting port 96, described later, by inserting the slide sections 68S of the connection board 68 into the pair of groove portions 88. Moreover, the sub-side connector 72 is guided into the main-side connector 46 by sliding the connection board 68 along the pair of groove portions 88.

As illustrated in Fig. 9, a circular shaped shaft receiving hole 90 is formed in the guide rails 80 on the opposite side to the main board 44. Circular rod shaped pivot shaft portion 39 that projects out from the bottom wall section 24 of the mounting case 22 is inserted into each of the shaft receiving holes 90. The guide rails 80 are thereby supported so as to be capable of pivoting in the mounting case 22 about the pivot shaft portions 39 that extend in the main board 44 board thickness direction.

Note that an anchor portion 39A is formed to the pivot shaft portion 39 so as to anchor to a peripheral edge portion of the shaft receiving hole 90. Configuration is such that each of the pivot shaft portions 39 is restricted from coming out from the shaft receiving hole 90 by the anchor portion 39A. Attachment holes 92 are also formed in the guide rails 80 with a larger diameter than the shaft receiving holes 90, so that the anchor portion 39A of each of the pivot shaft portions 39 is able to pass through. Each of the attachment holes 92 touches the respective shaft receiving hole 90, and is connected to the shaft receiving hole 90. Configuration is such that the pivot shaft portion 39 is placed in the shaft receiving hole 90 through the attachment hole 92.

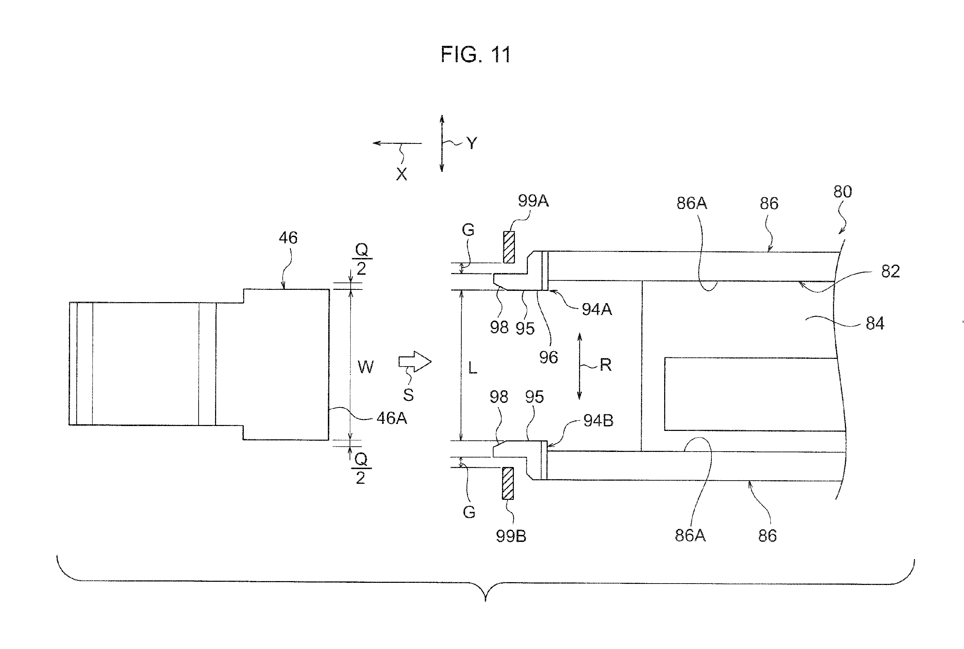

As illustrated in Fig. 11, a pair of engaging tabs 94A, 94B are provided to an end portion on the main board 44 side of the pair of side fixing portions 86, such that the main-side connector 46 is fitted between the engaging tabs 94A, 94B. The pair of engaging tabs 94A, 94B are positioned further to the inside than the inside faces 86A of the pair of side wall portions 86 (on the central side of the guide indentations 82), and included a pair of engagement faces 95 that face each other in the guide rail 80 pivot direction (arrow R direction). A separation L between the pair of engagement faces 95 is slightly larger than a width W of the main-side connector 46 (L > W). The fitting port 96 into which the main-side connector 46 is inserted is accordingly formed between the pairs of engagement faces 95. Each of the fitting ports 96 is positioned on the extension line of the respective guide indentation 82.

The end portions on the main board 44 side of the pair of engaging tabs 94A, 94B configure edge portions on the two guide rail 80 pivot direction sides of the fitting ports 96. A pair of sloping portions 98 are formed to end portions on the main board 44 side of the pair of engaging tabs 94A, 94B so as to slope away from each other on progression towards the opening side (entrance side). The guide rail 80 pivots due to one of the pair of sloping portions 98 being pressed by the outer peripheral edge portion 46A of the main-side connector 46, in a configuration in which the main-side connector 46 is guided along the pair of sloping portions 98 and into the fitting port 96.

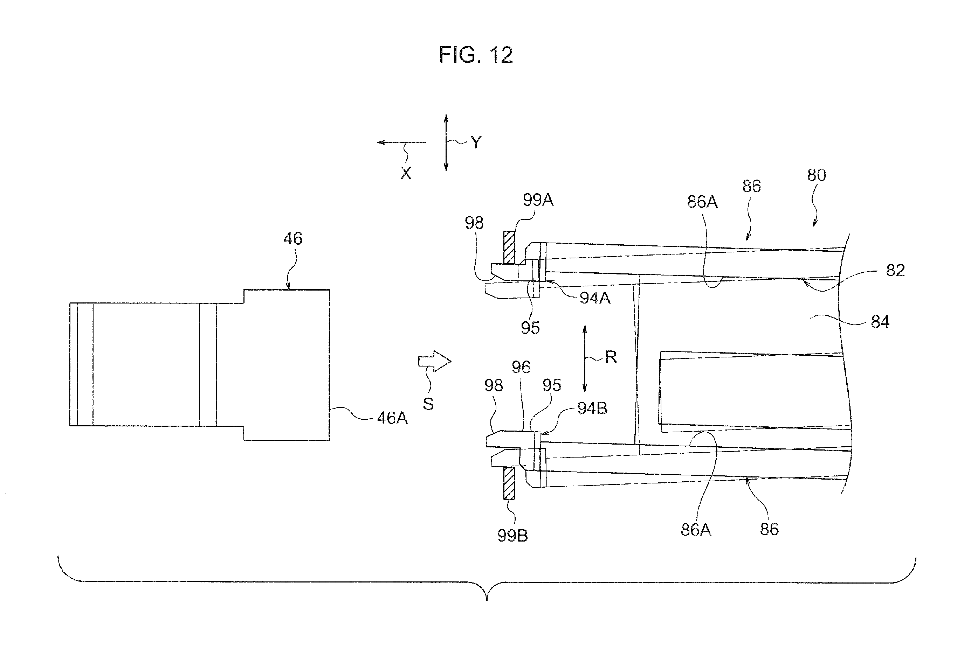

A pair of stoppers 99A, 99B is provided at the two pivot direction sides of the pair of engaging tabs 94A, 94B to control the pivot range of each of the guide rails 80. Gaps G are formed between the pair of stoppers 99A, 99B and the pair of engaging tabs 94A, 94B. As illustrated by the solid lines and the double dot broken lines in Fig. 12, each of the guide rails 80 is capable of pivoting in the pivot direction over a range permitted by the two gaps G.

Note that the two gaps G are set in a range permitting insertion of the main-side connector 46 between the pair of sloping portions 98. Specifically, the main-side connectors 46 are positioned in the main board width direction with respect to the mounting case 22 by the pair of engaging pins 32 and the pair of engaged holes 34. If Q denotes the positioning tolerance of the main-side connector 46 in the main board 44 width direction arising from the pair of engaging pins 32 and the pair of engaged holes 34, the tolerance Q and the gaps G are determined such that W + Q ≤ L + 2G.

Explanation next follows regarding an example of a method of connecting together the main board 44 and the sub board 66 (an electronic device manufacturing method).

First, as illustrated in Fig. 2 and Fig. 3, the main unit 40 is inserted into the main unit housing section 22A of the mounting case 22 through the insertion opening 28 formed at one side of the mounting case 22. When doing so, the main unit 40 is inserted along the pair of guide wall sections 26 of the mounting case 22 and into the main unit housing section 22A. The pair of engaging pins 32 provided on the far side of the main unit housing section 22A are thereby respectively inserted into the pair of engagement grooves 48 (see Fig. 4) formed at the insertion direction front side of the main unit case 42. Moreover, as illustrated in Fig. 5, the engaging pins 50 provided to the rear wall section 42C of the main unit case 42 are inserted into the engaged holes 34 of the brackets 36 that are provided to the guide wall sections 26 of the mounting case 22. As a result, the main unit 40 is positioned in the device width direction and device up-down direction with respect to the mounting case 22. Namely, the main board 44 is positioned in the board width direction and thickness direction with respect to the mounting case 22. Then in this state, the main-side connectors 46 are fitted into the fitting ports 96 of the guide rails 80 by inserting the main unit 40 further into the mounting case 22.

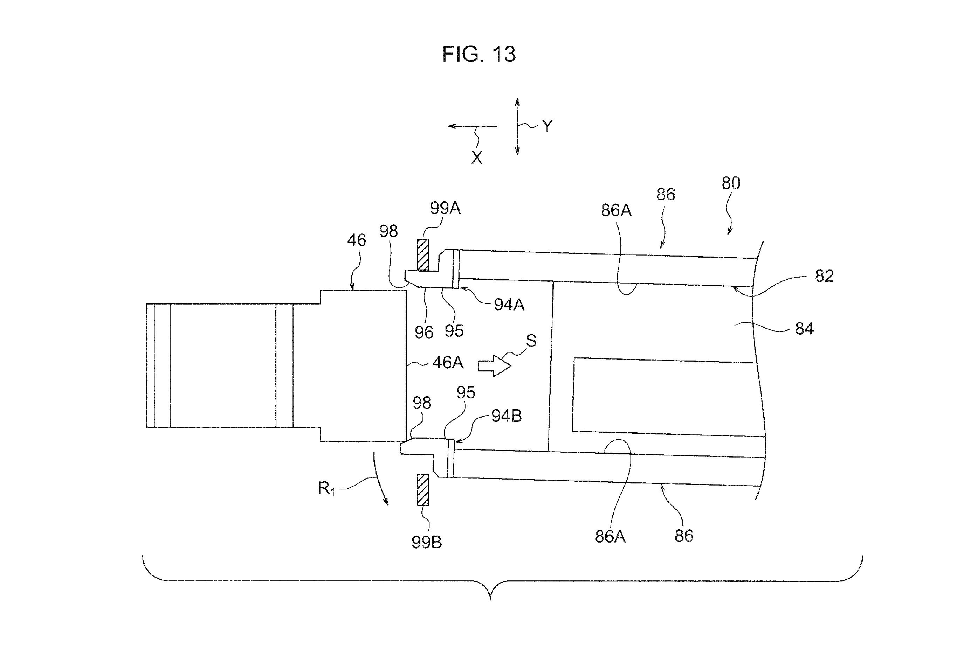

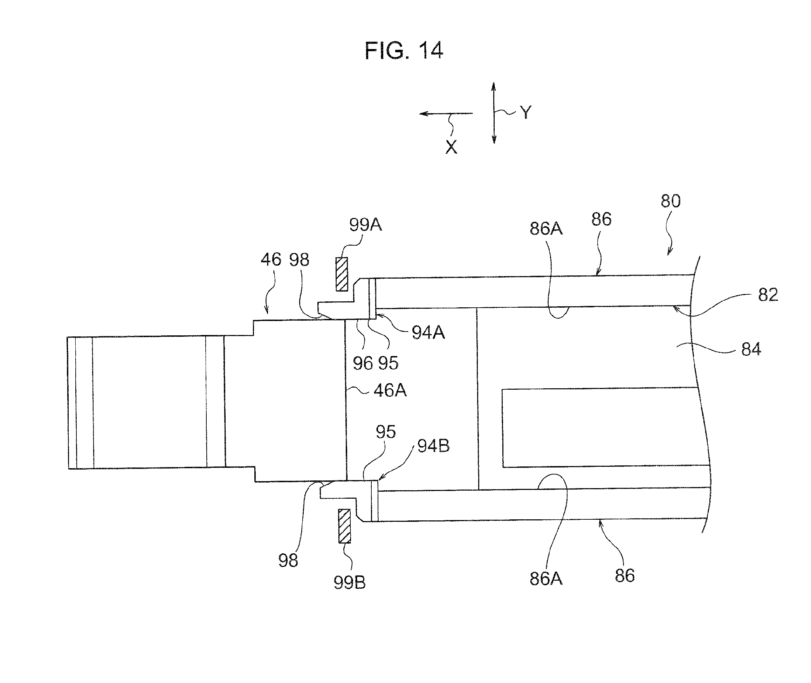

Specifically, for example, as illustrated in Fig. 13, in a state in which the one engaging tab 94A out of the pair of engaging tabs 94A, 94B of the guide rails 80 makes contact with the one stopper 99A adjacent thereto, the following occurs when the main unit 40 is inserted into the mounting case 22. An outer peripheral edge portion 46A of the main-side connector 46 makes contact with the sloping portion 98 formed to the other engaging tab 94B, and presses the sloping portion 98 in the main unit 40 insertion direction (arrow S direction). The guide rail 80 is accordingly swung towards the other stopper 99B side (the arrow R₁ direction), and the main-side connector 46 is guided along the sloping portion 98 towards the fitting port 96. The main-side connector 46 is thus, as illustrated in Fig. 14, fitted into the fitting port 96.

In this state, the bolt 52 provided to the rear wall section 42C of the main unit case 42 (see Fig. 5) is fastened into the nut 38 provided to the bracket 36 of the mounting case 22, thereby fixing the main unit 40 to the mounting case 22.

Then, as illustrated in Fig. 4, the sub unit 60 is inserted into the sub unit housing section 22B inside the mounting case 22 through the insertion opening 30 formed at the other side of the mounting case 22. When this is performed, the sub unit 60 is inserted into the sub unit housing section 22B along the respective guide rail 80.

Specifically, the sub-side connector 72 is introduced into the guide indentation 82 of the respective guide rail 80 and the slide sections 68S on both sides of the connection board 68 are respectively inserted into the pair of groove portions 88 formed in the guide indentation 82, with the connection board 68 sliding along the pair of groove portions 88. The sub-side connector 72 is thereby guided towards the respective main-side connector 46 that has been fitted into the fitting port 96. Moreover, the insertion portion 74 of the sub-side connector 72 is inserted into the connection port 47 of the main-side connector 46, so as to connect together the main-side connector 46 and the sub-side connector 72. During this procedure, insertion of the insertion portion 74 with respect to the connection port 47 is guided by the beveled portions 47A, 74A respectively formed on the inner peripheral edge portions of the connection port 47 and the outer peripheral edge portions of the insertion portion 74.

Thus in present exemplary embodiment, the main-side connectors 46 are directly positioned with respect to the guide rails 80 by fitting each of the main-side connectors 46 into the fitting ports 96 of the respective guide rails 80. The amount of positional misalignment of the guide rails 80 with respect to the main-side connector 46 is accordingly reduced, enabling relaxation of the precision (positioning precision) demanded of the respective guide rails 80 to guide the sub unit 60 (the sub-side connector 72). This thereby enables a reduction in manufacturing cost of the guide rails 80 to be achieved.

Moreover, in the present exemplary embodiment, there is no reduction in mounting space for electronic components on the main board 44 due to the guide rails 80 each being attached to the respective main-side connector 46 rather than to the main board 44. Namely, the present exemplary embodiment enables a lessening of the reduction in electronic component mounting space on the main board 44 to be achieved. Moreover, the present exemplary embodiment enables the main-side connectors 46 to be directly positioned with respect to the guide rails 80 without reducing the electronic component mounting space on the main board 44. A higher electronic component density on the main board 44 is accordingly enabled. As a result a more compact main board 44 is enabled.

Moreover, in the present exemplary embodiment, the guide rails 80 are each supported so as to be capable of pivoting with respect to the mounting case 22, and are formed with the pair of sloping portions 98 on the two guide rail 80 pivot direction side edge portions of the fitting ports 96. Accordingly, the respective guide rails 80 pivot when one of the pair of sloping portions 98 is pressed by the main-side connector 46, thereby accommodating any positional misalignment of the main-side connector 46 in the main board 44 width direction with respect to the fitting port 96.

In the present exemplary embodiment plural of the main-side connectors 46 are provided to the main board 44. Thus there is a possibility of a difference in positional misalignment amount to the main board 44 occurring between the plural main-side connectors 46. However, in the present exemplary embodiment, each of the guide rails 80 independently pivots according to the positional misalignment amount of the respective main-side connector 46 when the main unit 40 is being housed in the mounting case 22. Hence the assembly precision of the plural main-side connectors 46 with respect to the main board 44 is relaxed due to any such difference in positional misalignment amount between the plural main-side connectors 46 being accommodated in this manner. A reduction is accordingly enabled in the manufacturing cost of the main board 44.

Moreover, in the present exemplary embodiment, the pairs of stoppers 99A, 99B that restrict the pivot range of the guide rails 80 are disposed on the fitting port 96 side of the guide rails 80. Namely, the pairs of stoppers 99A, 99B are disposed at positions in the vicinity of the fitting ports 96. Thus better restriction precision of the pivot range of the guide rails 80 is enabled compared to configurations in which the pairs of stoppers 99A, 99B are disposed at end portions on the opposite side of the guide rails 80 to the fitting ports 96.

Moreover, in the present exemplary embodiment, the pivot shaft portions 39 are positioned on the opposite side of the guide rails 80 to the fitting ports 96 and the pairs of stoppers 99A, 99B are positioned on the fitting port 96 side of the guide rails 80. Namely, the pairs of stoppers 99A, 99B are disposed at a distance from the center of pivoting of the guide rails 80. A wider spacing between the pairs of stoppers 99A, 99B that restrict the pivot range of the guide rails 80 is accordingly achieved than in configurations in which the pairs of stoppers 99A, 99B are disposed in the vicinity of the center of pivoting of the guide rails 80. Placement of the guide rails 80 between the pairs of stoppers 99A, 99B is accordingly facilitated, and hence the ease of assembly of the guide rails 80 to the mounting case 22 is raised.

Moreover, in the mounting case 22, the pair of engaging pins 32 are provided for positioning at the main unit 40 insertion direction front side, and the pair of engaged holes 34 are provided for positioning at the main unit 40 insertion direction rear side. The positioning precision of the main unit 40 and the main board 44 with respect to the mounting case 22 is accordingly raised.

Explanation next follows regarding modified examples of the above exemplary embodiment.

In the above exemplary embodiment, an example has been given in which the fitting ports 96 are each formed between the pair of engaging tabs 94A, 94B, however the shape of the fitting ports 96 may be modified as appropriate. Moreover, although in the above exemplary embodiment the fitting ports 96 are disposed on the extension lines of the guide indentations 82 of the guide rails 80, there is no limitation thereto. Placement of the fitting ports 96 may be changed as appropriate according to the positions of main-side connectors 46 and the sub-side connector 72.

Moreover, in the present exemplary embodiment an example is given in which the pivot shaft portions 39 are provided on the opposite side of the guide rails 80 to the fitting ports 96, however the position of the pivot shaft portions 39 with respect to the guide rails 80 may be modified as appropriate. Moreover, although in the above exemplary embodiment an example has been given in which the pivot shaft portions 39 are provided to the mounting case 22, pivot shaft portions may be provided to the guide rails 80, and shaft bearing portions to support the pivot shaft portions may be provided to the mounting case 22.

Moreover, in the above exemplary embodiment, the pairs of stoppers 99A, 99B are disposed on the fitting port 96 side of the guide rails 80, however the placement of the pair of stoppers 99A, 99B may be modified as appropriate.

Moreover, although in the above exemplary embodiment an example is given in which the slide sections 68S are provided to the connection board 68 of the sub unit 60, there is no limitation thereto. For example, slide sections may be provided to the sub unit case 62 of the sub unit 60. Moreover, the guide structure of the guide rails 80 for guiding the sub unit 60 may be modified as appropriate. Moreover, in the above exemplary embodiment, although an example is given in which the sub board 66 is slidably supported by the guide rails 80 indirectly through the connection board 68, there is no limitation thereto. For example, the sub board 66 may be slidably supported directly by the guide rails 80.

Moreover, in the above exemplary embodiment, although an example is given in which the sub-side connector 72 is connected to the sub board 66 through the connection board 68, the sub-side connector 72 may be directly connected to the sub board 66.

Moreover, although in the above exemplary embodiment an example is given in which plural of the main-side connectors 46 are provided to the main board 44, there is no limitation thereto. One or more than one of the main-side connectors 46 may be provided to the main board 44. In such cases the number of the guide rails 80 may be adjusted according to the number of the main-side connectors 46. Moreover, the placement of the main-side connectors 46 with respect to the main board 44 may also be modified as appropriate.

Moreover, in the above exemplary embodiments, an example is given in which the pair of engaging pins 32 and the pair of engaged holes 34 are provided to the mounting case 22 as front side positioning sections and rear side positioning sections, respectively, however there is no limitation thereto. The positioning structures and placements of the front side positioning section and the rear side positioning section may be modified as appropriate. Moreover, one or more than one of positioning section may be provided to the mounting case 22 for positioning the main board 44 with respect to the mounting case 22.

Moreover, in the above exemplary embodiment, although an example is given in which the main unit 40 is housed in the mounting case 22, configuration may be made such that the main board 44 is housed (inserted) directly in the mounting case 22. In a similar manner, although an example is given in the above exemplary embodiment in which the sub unit 60 is housed in the mounting case 22, configuration may be made such that the sub board 66 is directly housed (inserted) into the mounting case 22.

Although the technology disclosed herein has been explained by way of exemplary embodiments, the technology disclosed herein is not limited to the above exemplary embodiments. Moreover, obviously appropriate combinations may be made from the above exemplary embodiments and each of the modified examples, and various embodiments may be obtained within a range not departing from the spirit of the present invention.

## Claims

1. An electronic device (20) comprising:
a case (22);
a first board (44) that includes a first connector (46) and that is inserted into one side of the case (22);
a positioning section (32, 34) that is provided to the case (22) and that positions the first board (44) with respect to the case (22);
a second board (66) that includes a second connector (72) that connects to the first connector (46), and that is inserted into another side of the case (22) from the opposite side to the first board (44);
a guide rail (80) that is disposed along the second board (66) insertion direction at the other side of the case (22), that is pivotally supported by the case (22), that has an end portion on the first board (44) side formed with a fitting port (96) into which the first connector (46) fits, that slidably supports the second board (66), and that guides the second connector (72) towards the first connector (46) that is fitted into the fitting port (96);
a pair of sloping portions (98) formed to edge portions on both guide rail (80) pivot direction sides of the fitting port (96) so as to slope in the direction separating from each other on progression towards the open side; and
a pair of stoppers (99A, 99B) respectively disposed at each of the guide rail (80) pivot direction sides so as to restrict the pivot range of the guide rail (80) such that the first connector (46) is insertable between the pair of sloping portions (98).

2. The electronic device (20) of claim 1, wherein the guide rail (80) is supported from the case (22) so as to capable of pivoting about a pivot shaft portion (39) that extends in the first board (44) board thickness direction.

3. The electronic device (20) of claim 2, wherein:
the pivot shaft portion (39) is positioned on the opposite side of the guide rail (80) to the fitting port (96); and
the pair of stoppers (99A, 99B) are positioned on the fitting port (96) side of the guide rail (80).

4. The electronic device (20) of claim 2 or claim 3, wherein:
the first board (44) includes a plurality of the first connectors (46) arrayed along a width direction of the first board (44); and
a plurality of the guide rails (80) are arrayed along the first board (44) width direction.

5. The electronic device (20) of any one of claim 1 to claim 4, wherein the positioning section (32,34) comprises a front side positioning section (32) that positions the first board at the insertion direction front side and a rear side positioning section (34) that positions the first board at the insertion direction rear side.

6. The electronic device (20) of any one of claim 1 to claim 5, wherein:
the first connector (46) and the second connector (72) are connected together by inserting, into a connection port (47) that is formed to one of the first connector (46) or the second connector (72), an insertion portion (74) that is formed to the other of the first connector (46) or the second connector (72); and
a beveled portion (47A, 74A) that guides the insertion portion (74) towards the connection port (47) is formed to an inner peripheral edge portion of the connection port (47) or to an outer peripheral edge portion of the insertion portion (74) or to a combination thereof.

7. The electronic device (20) of any one of claim 1 to claim 6, further comprising a second board unit (60) that houses the second board (66) and that is detachably housed along the guide rail (80) at the other side of the case (22).

8. The electronic device (20) of any one of claim 1 to claim 7, further comprising a first board unit (40) that houses the first board (44) and that is inserted into the other side of the case (22).

9. A manufacturing method of an electronic device (20), the method comprising:
inserting a first board (44) that includes a first connector (46) into one side of a case (22);
causing an outer peripheral edge portion (46A) of a first connector (46) to contact either of a pair of sloping portions (98) respectively formed to each pivot direction edge portion of a fitting port (96) of a guide rail (80) that is pivotally supported at another side of the case (22);
fitting the first connector (46) into the fitting port (96) while pivoting the guide rail (80);
inserting a second board (66) that includes a second connector (72) into the case (22) along the guide rail (80) from the opposite side to the first board (44); and
connecting the second connector (72) to the first connector (46).

10. A connection method for boards included in an electronic device (20), the method comprising:
inserting a first board (44) that includes a first connector (46) into one side of a case (22);
causing an outer peripheral edge portion (46A) of a first connector (46) to contact either of a pair of sloping portions (98) respectively formed to each pivot direction edge portion of a fitting port (96) of a guide rail (80) that is pivotally supported at another side of the case (22);
fitting the first connector (46) into the fitting port (96) while pivoting the guide rail (80);
inserting a second board (66) that includes a second connector (72) into the case (22) along the guide rail (80) from the opposite side to the first board (44); and
connecting the second connector (72) to the first connector (46).
